# EUROPEAN PATENT APPLICATION

(11) **EP 4 191 887 A1**
(43) Date of publication of application: **07.06.2023**
(21) Application number: 20950946.2
(22) Date of filing: 31.08.2020
(51) Int. Cl.: H03L 7/08

(54) **PHASE-LOCKED LOOP AND RADIO FREQUENCY TRANSCEIVER**

(71) Applicant: Huawei Technologies Co., Ltd., Shenzhen, Guangdong 518129 (CN)
(72) Inventor: GUO, Na, Shenzhen, Guangdong 518129 (CN); LIU, Dang, Shenzhen, Guangdong 518129 (CN)
(74) Representative: Goddar, Heinz J.
(86) International application number: PCT/CN2020/112728
(87) International publication number: WO 2022/041277

(57) **Abstract**

A phase locked loop (10) and a radio frequency transceiver are provided, relate to the wireless communication field, and are used to reduce noise of a divider (35) and a charge pump (32), and reduce phase noise of the phase locked loop (10) working at a decimal frequency. The phase locked loop (10) includes a phase detector (31), the charge pump (32), a low-pass filter (33), a voltage-controlled oscillator (34), and the divider (35). The voltage-controlled oscillator (34) outputs an oscillation signal. The divider (35) receives the oscillation signal, and outputs a first frequency division signal (DIV1) and a second frequency division signal (DIV2). The phase detector (31) receives a reference signal (REF), the first frequency division signal (DIV1), and the second frequency division signal (DIV2), and outputs a charge pump control signal based on one of the first frequency division signal (DIV1) and the second frequency division signal (DIV2) and the reference signal (REF). The charge pump (32) includes a variable current source (A0) and first current source units (321) connected in parallel that are coupled to an output end of the charge pump (32). The first current source unit (321) includes a fixed current source (A1 to AM) and a switch (K1 to KM) that are connected in series. The variable current source (A0) receives an offset control signal, and the offset control signal is used to adjust a current value of the variable current source (A0). The charge pump control signal is used to control on/off of switches (K1 to KM) of the first current source units (321). The low-pass filter (33) is configured to filter an output current of the charge pump (32) and then output the output current to the voltage-controlled oscillator (34).

## Description

### TECHNICAL FIELD

This application relates to the wireless communication field, and in particular, to a phase locked loop (phase locked loop, PLL) and a radio frequency transceiver.

### BACKGROUND

A phase locked loop is used in a wireless transmission transceiver to synchronize phases of radio frequency signals. As a wireless signal is transmitted at an increasingly high speed, more radio frequency channels and antennas and a higher modulation order are required. Both a lower inter-channel phase deviation and a higher modulation order impose a higher requirement on phase noise of the PLL.

Each channel of a radio frequency transceiver link has a specific frequency, and the PLL inevitably works at a decimal frequency (a non-integer frequency) at specific frequencies. Phase noise of a PLL working at the decimal frequency mainly is from a reference clock, a charge pump (charge pump, CP), a voltage-controlled oscillator (voltage control oscillator, VCO), and a divider.

### SUMMARY

Embodiments of this application provide a phase locked loop and a radio frequency transceiver, to reduce noise of a divider and a CP, so that phase noise of the PLL working at a decimal frequency is reduced.

To achieve the foregoing objectives, the following technical solutions are used in embodiments of this application.

According to a first aspect, a phase locked loop is provided, and includes a phase detector, a charge pump CP, a low-pass filter LPF, a voltage-controlled oscillator VCO, and a divider. The VCO is configured to output an oscillation signal. The divider is configured to: after receiving the oscillation signal, output a first frequency division signal and a second frequency division signal. The phase detector is configured to receive a reference signal, the first frequency division signal, and the second frequency division signal, and is further configured to output a plurality of charge pump control signals based on one of the first frequency division signal and the second frequency division signal and the reference signal. The CP includes a variable current source and a plurality of first current source units connected in parallel, and the variable current source and the plurality of first current source units are coupled to an output end of the charge pump. Each first current source unit includes a fixed current source and a switch that are connected in series. The variable current source is configured to receive an offset control signal, and the offset control signal is used to adjust a current value of the variable current source. The plurality of charge pump control signals are used to control on/off of switches of the plurality of first current source units. The LPF is configured to filter an output current of the CP and then output the output current to the VCO.

According to the phase locked loop and a radio frequency transceiver provided in this embodiment of this application, in one aspect, the first frequency division signal and the second frequency division signal are output by using the divider in the phase locked loop, so that width of the charge pump control signal output by the phase detector in the phase locked loop is between the following two phase differences: a phase difference between the first frequency division signal and the reference signal, and a phase difference between the second frequency division signal and the reference signal. Because the reference signal always remains unchanged, a smaller phase difference between the first frequency division signal and the second frequency division signal leads to smaller variation of the width of the charge pump control signal output by the phase detector and smaller fluctuation of the oscillation signal output by the VCO, so that noise of the divider is reduced, and therefore, phase noise of the PLL working at a decimal frequency is reduced. In another aspect, the CP in the phase locked loop includes the fixed current source and the variable current source with an adjustable size. When the size of the variable current source is reduced, charging and discharging time of the fixed current source can be reduced, noise of the CP is reduced, and the phase noise of the PLL working at the decimal frequency is reduced. In addition, the variable current source with an adjustable size is used in the CP, so that the phase locked loop can adjust charging and discharging time of the CP in a specific range, to optimize performance of the phase locked loop in a specific parameter range.

In a possible implementation, the phase detector may include a phase detector PD, a phase frequency detector PFD, or another component used for phase detection.

In a possible implementation, the plurality of first current source units are connected in parallel, and are connected to the variable current source in series and coupled to the output end of the charge pump, and when the charge pump control signal is a discharge DOWN signal, the variable current source is connected to a power supply, and fixed current sources of the plurality of first current source units are grounded. A possible structure of the CP is provided in this implementation.

In a possible implementation, the plurality of first current source units are connected in parallel, and are connected to the variable current source in series and coupled to the output end of the charge pump, and when the charge pump control signal is a charge UP signal, the variable current source is grounded, and fixed current sources of the plurality of first current source units are connected to a power supply. Another possible structure of the CP is provided in this implementation.

In a possible implementation, the phase detector includes a NOT gate and an AND gate, the NOT gate is configured to invert a phase of the reference signal and then output the phase-inverted reference signal to the AND gate, and the AND gate is configured to perform an AND operation on the first frequency division signal or the second frequency division signal and the phase-inverted reference signal and then output a DOWN signal. A possible structure of the phase detector is provided in this implementation.

In a possible implementation, the phase detector includes a NOT gate and an AND gate, the NOT gate is configured to invert a phase of the first frequency division signal or the second frequency division signal and then output the phase-inverted first frequency division signal or second frequency division signal to the AND gate, and the AND gate is configured to perform an AND operation on the phase-inverted first frequency division signal or second frequency division signal and the reference signal and then output an UP signal. Another possible structure of the phase detector is provided in this implementation.

In a possible implementation, the phase detector includes a first AND gate, a second AND gate, a first NOT gate, and a second NOT gate, the first NOT gate is configured to invert a phase of the first frequency division signal or the second frequency division signal and then output the phase-inverted first frequency division signal or second frequency division signal to the first AND gate, the second NOT gate is configured to invert a phase of the reference signal and then output the phase-inverted reference signal to the second AND gate, the first AND gate is configured to perform an AND operation on the phase-inverted first frequency division signal or second frequency division signal and the reference signal and then output an UP signal, and the second AND gate is configured to perform an AND operation on the first frequency division signal or the second frequency division signal and the phase-inverted reference signal and then output a DOWN signal. Still another possible structure of the phase detector is provided in this implementation.

In a possible implementation, the phase detector includes a third trigger, a fourth trigger, and an AND gate. A clock input end of the third trigger is configured to input the reference signal, and a data output end of the third trigger is configured to output the UP signal; a clock input end of the fourth trigger is configured to input the first frequency division signal or the second frequency division signal, and a data output end of the fourth trigger is configured to output the DOWN signal; and a first input end of the AND gate is configured to input the UP signal, a second input end of the AND gate is configured to input the DOWN signal, and an output end of the AND gate is coupled to reset input ends of the third trigger and the fourth trigger. Yet another possible structure of the phase detector is provided in this implementation.

In a possible implementation, the divider includes an N-divider NDIV and a multiplexer MUX. The NDIV is configured to: receive the oscillation signal and a frequency division value, perform frequency division on the oscillation signal based on the frequency division value, and output the first frequency division signal and the second frequency division signal; and the MUX is configured to: after a selection control signal, the first frequency division signal, and the second frequency division signal are input, select one of the first frequency division signal and the second frequency division signal based on the selection control signal, and output the selected frequency division signal to the phase detector. A possible structure of the divider is provided in this implementation.

In a possible implementation, the NDIV includes a counter, a first trigger, and a second trigger. The counter is configured to input the oscillation signal and perform frequency division on the oscillation signal to output an initial frequency division signal, a data input end of the first trigger is configured to input the initial frequency division signal, a data output end of the first trigger is configured to output the first frequency division signal, a data input end of the second trigger is configured to input the first frequency division signal, and a data output end of the second trigger is configured to output the second frequency division signal. A possible structure of the NDIV is provided in this implementation.

In a possible implementation, the variable current source includes a plurality of parallel third current source units, and each third current source unit includes an image constant current source and a switching transistor that are connected in series, a gate of the image constant current source is controlled by a same bias voltage, and on/off of the switching transistor is controlled by the offset control signal. A possible structure of the variable current source is provided in this implementation.

In a possible implementation, a phase of the second frequency division signal lags behind a phase of the first frequency division signal. In other words, phases of the two frequency division signals are different.

According to a second aspect, a phase locked loop is provided, and includes a phase detector, a charge pump CP, a low-pass filter LPF, a voltage-controlled oscillator VCO, and a divider. The VCO is configured to output an oscillation signal. The divider is configured to: after receiving the oscillation signal, output a first frequency division signal and a second frequency division signal. The phase detector is configured to receive a reference signal, the first frequency division signal, and the second frequency division signal, and is further configured to output a plurality of charge pump control signals based on one of the first frequency division signal and the second frequency division signal and the reference signal. The CP includes a plurality of groups of current sources that are connected in parallel, and each group of current sources includes a first current source unit and a second current source unit that are connected in series. The first current source unit includes a first fixed current source and a first switch, and the second current source unit includes a second fixed current source and a second switch. A plurality of charge pump control signals output by the phase detector are used to separately control on/off of the first switch and the second switch. The LPF is configured to filter an output current of the CP and then output the output current to the VCO.

According to the phase locked loop and a radio frequency transceiver provided in this embodiment of this application, the first frequency division signal and the second frequency division signal are output by using the divider in the phase locked loop, so that width of the charge pump control signal output by the phase detector in the phase locked loop is between the following two phase differences: a phase difference between the first frequency division signal and the reference signal, and a phase difference between the second frequency division signal and the reference signal. Because the reference signal always remains unchanged, a smaller phase difference between the first frequency division signal and the second frequency division signal leads to smaller variation of the width of the charge pump control signal output by the phase detector and smaller fluctuation of the oscillation signal output by the VCO, so that noise of the divider is reduced, and therefore, phase noise of the PLL working at a decimal frequency is reduced.

In a possible implementation, the phase detector may include a phase detector PD, a phase frequency detector PFD, or another component used for phase detection.

In a possible implementation, the first fixed current source is connected to a power supply, the second fixed current source is grounded, a connection point of the first current source unit and the second current source unit is used to connect an input end of the LPF, the charge pump control signal includes a charge UP signal and a discharge DOWN signal, the UP signal is used to control on/off of the first switch, and the DOWN signal is used to control on/off of the second switch. A possible structure of the CP is provided in this implementation.

In a possible implementation, the phase detector includes a NOT gate and an AND gate, the NOT gate is configured to invert a phase of the reference signal and then output the phase-inverted reference signal to the AND gate, and the AND gate is configured to perform an AND operation on the first frequency division signal or the second frequency division signal and the phase-inverted reference signal and then output a DOWN signal. A possible structure of the phase detector is provided in this implementation.

In a possible implementation, the phase detector includes a NOT gate and an AND gate, the NOT gate is configured to invert a phase of the first frequency division signal or the second frequency division signal and then output the phase-inverted first frequency division signal or second frequency division signal to the AND gate, and the AND gate is configured to perform an AND operation on the phase-inverted first frequency division signal or second frequency division signal and the reference signal and then output an UP signal. Another possible structure of the phase detector is provided in this implementation.

In a possible implementation, the phase detector includes a first AND gate, a second AND gate, a first NOT gate, and a second NOT gate, the first NOT gate is configured to invert a phase of the first frequency division signal or the second frequency division signal and then output the phase-inverted first frequency division signal or second frequency division signal to the first AND gate, the second NOT gate is configured to invert a phase of the reference signal and then output the phase-inverted reference signal to the second AND gate, the first AND gate is configured to perform an AND operation on the phase-inverted first frequency division signal or second frequency division signal and the reference signal and then output an UP signal, and the second AND gate is configured to perform an AND operation on the first frequency division signal or the second frequency division signal and the phase-inverted reference signal and then output a DOWN signal. Still another possible structure of the phase detector is provided in this implementation.

In a possible implementation, the phase detector includes a third trigger, a fourth trigger, and an AND gate. A clock input end of the third trigger is configured to input the reference signal, and a data output end of the third trigger is configured to output the UP signal; a clock input end of the fourth trigger is configured to input the first frequency division signal or the second frequency division signal, and a data output end of the fourth trigger is configured to output the DOWN signal; and a first input end of the AND gate is configured to input the UP signal, a second input end of the AND gate is configured to input the DOWN signal, and an output end of the AND gate is coupled to reset input ends of the third trigger and the fourth trigger. Yet another possible structure of the phase detector is provided in this implementation.

In a possible implementation, the divider includes an N-divider NDIV and a multiplexer MUX. The NDIV is configured to: receive the oscillation signal and a frequency division value, perform frequency division on the oscillation signal based on the frequency division value, and output the first frequency division signal and the second frequency division signal; and the MUX is configured to: after a selection control signal, the first frequency division signal, and the second frequency division signal are input, select one of the first frequency division signal and the second frequency division signal based on the selection control signal, and output the selected frequency division signal to the phase detector. A possible structure of the divider is provided in this implementation.

In a possible implementation, the NDIV includes a counter, a first trigger, and a second trigger. The counter is configured to input the oscillation signal and perform frequency division on the oscillation signal to output an initial frequency division signal, a data input end of the first trigger is configured to input the initial frequency division signal, a data output end of the first trigger is configured to output the first frequency division signal, a data input end of the second trigger is configured to input the first frequency division signal, and a data output end of the second trigger is configured to output the second frequency division signal. A possible structure of the NDIV is provided in this implementation.

In a possible implementation, a phase of the second frequency division signal lags behind a phase of the first frequency division signal. In other words, phases of the two frequency division signals are different.

According to a third aspect, a radio frequency transceiver is provided, and includes the phase locked loop according to the first aspect or the second aspect and any implementation thereof, a local oscillator, and a plurality of groups of radio frequency circuits. Each group of radio frequency circuits includes a first mixer and a low noise amplifier. The phase locked loop is configured to output a first oscillation signal to the local oscillator. The local oscillator is configured to process the first oscillation signal (optionally, perform frequency division, and optionally, output orthogonal phases) and output a receive oscillation signal. In each radio frequency circuit, the first mixer is configured to mix the receive oscillation signal and a signal that is output by the low noise amplifier.

According to a fourth aspect, a radio frequency transceiver is provided, and includes the phase locked loop according to the first aspect or the second aspect and any implementation thereof, a local oscillator, and a plurality of groups of radio frequency circuits. Each group of radio frequency circuits includes a second mixer, a transmit analog baseband, and a power amplifier. The phase locked loop is configured to output a first oscillation signal to the local oscillator. The local oscillator is configured to process the first oscillation signal (optionally, perform frequency division, and optionally, output orthogonal phases) and output a transmit oscillation signal. In each group of radio frequency circuits, the second mixer is configured to mix the transmit oscillation signal and output the transmit oscillation signal to the power amplifier.

For technical effects of the third aspect and the fourth aspect, refer to the technical effects of the first aspect or the second aspect and any implementation thereof.

### BRIEF DESCRIPTION OF DRAWINGS

FIG. 1 is a schematic diagram of a structure of a multi-antenna radio frequency transceiver according to an embodiment of this application;
FIG. 2 is a schematic diagram of a structure of a charge pump-based PLL according to an embodiment of this application;
FIG. 3 is a schematic diagram 1 of a structure of a charge pump-based PLL according to an embodiment of this application;
FIG. 4 is a schematic diagram 2 of a structure of a charge pump-based PLL according to an embodiment of this application;
FIG. 5 is a schematic diagram 3 of a structure of a charge pump-based PLL according to an embodiment of this application;
FIG. 6 is a schematic diagram 4 of a structure of a charge pump-based PLL according to an embodiment of this application;
FIG. 7A, FIG. 7B, FIG. 7C, and FIG. 7D are schematic diagrams of a structure of a phase detector according to an embodiment of this application;
FIG. 8 is a schematic diagram 1 of a possible connection relationship among a divider, a phase detector, a CP, and an LPF according to an embodiment of this application;
FIG. 9 is a schematic diagram 2 of a possible connection relationship among a divider, a phase detector, a CP, and an LPF according to an embodiment of this application;
FIG. 10 is a schematic diagram 3 of a possible connection relationship among a divider, a phase detector, a CP, and an LPF according to an embodiment of this application; and
FIG. 11 is a schematic diagram of a structure of a variable current source according to an embodiment of this application.

### DESCRIPTION OF EMBODIMENTS

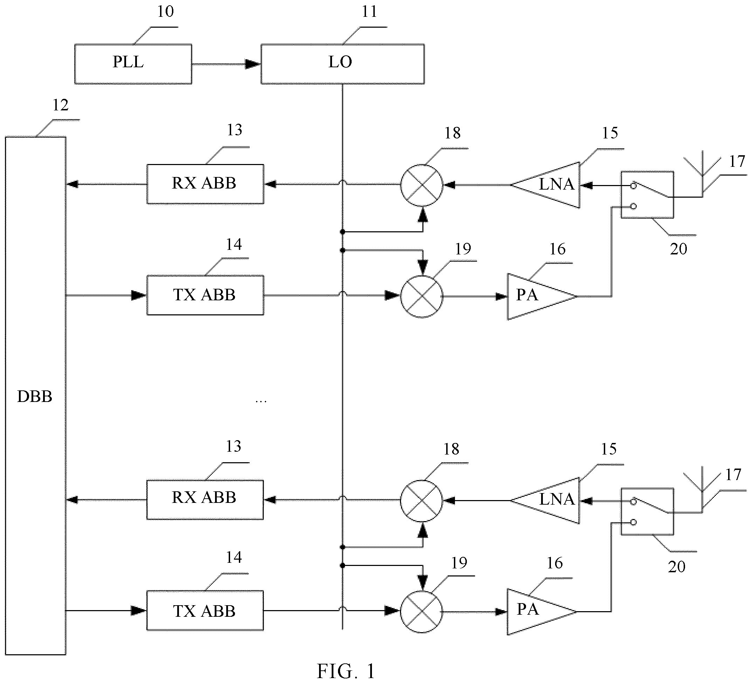

FIG. 1 shows a structure of a multi-antenna radio frequency transceiver. The multi-antenna radio frequency transceiver may be applied to a communication apparatus. The transceiver includes a phase locked loop (phase locked loop, PLL) 10, a local oscillator (local oscillator generator, LO) 11, a digital baseband (digital base band, DBB) 12, and a plurality of groups of radio frequency circuits. Each group of radio frequency circuits includes a receive analog baseband (receive analog base band, RX ABB) 13, a transmit analog baseband (transmit analog base band, TX ABB) 14, a low noise amplifier (low noise amplifier, LNA) 15, a power amplifier (power amplifier, PA) 16, an antenna 17, a first mixer 18, a second mixer 19, and an antenna switch 20.

First, a connection relationship between the foregoing components is described.

An output end of the PLL 10 is connected to an input end of the LO 11. For each group of radio frequency circuits, an output end of the LO 11 is connected to a first input end of the first mixer 18, and/or an output end of a frequency divider 11 may be connected to a first input end of the second mixer 19.

For a receive link of each group of radio frequency circuits, the antenna 17 is connected to an input end of the LNA 15 by using a first path of the antenna switch 20, an output end of the LNA 15 is connected to a second input end of the first mixer 18, an output end of the first mixer 18 is connected to an input end of the RX ABB 13, and an output end of the RX ABB 13 is connected to the DBB 12.

For a transmit link of each group of radio frequency circuits, the DBB 12 is connected to an input end of the TX ABB 14, an output end of the TX ABB 14 is connected to a second input end of the second mixer 19, an output end of the second mixer 19 is connected to an input end of the PA 16, and an output end of the PA 16 is connected to the antenna 17 by using a second path of the antenna switch 20.

Functions of the foregoing components are described below.

The PLL 10 is configured to output a first oscillation signal of a fixed clock frequency of each channel to the LO 11.

The LO 11 is configured to: process the first oscillation signal (optionally, perform frequency division, and optionally, output orthogonal phases) and output a plurality of transmit oscillation signals of a local oscillator frequency; or process the first oscillation signal (optionally, perform frequency division, and optionally, output orthogonal phases) and output a plurality of receive oscillation signals of a local oscillator frequency. The transmit oscillation signal and the receive oscillation signal may be the same or different.

The LNA 15 is configured to amplify a high-frequency analog signal that is received by using the antenna 17 and that carries a low-frequency modulation signal.

The first mixer 18 is configured to mix the receive oscillation signal and a signal that is output by the LNA 15, and output an obtained signal to the RX ABB 13.

The RX ABB 14 is configured to perform filtering, amplification processing, and analog-to-digital conversion on the signal that is output by the first mixer 18, to obtain a digital signal.

The DBB 12 is configured to: perform digital processing on a digital signal corresponding to a low-frequency modulation signal received by a receive link, or send a digital signal to a transmit link.

The TX ABB 13 is configured to perform filtering and amplification processing on the digital signal from the DBB 12.

The second mixer 19 is configured to: mix the transmit oscillation signal (optionally, and a signal output by the TX ABB 13), and output an obtained signal to the PA 16.

The PA 16 is configured to amplify a high-frequency signal obtained after mixing.

A communication apparatus in this embodiment of this application may be a device that includes a wireless transceiver function. The terminal may also be referred to as a terminal device, user equipment (user equipment, UE), an access terminal, a subscriber unit, a subscriber station, a mobile station, a remote station, a remote terminal, a mobile device, a user terminal, a terminal, a wireless communication device, a user agent, or a user apparatus. For example, the communication apparatus may be a mobile phone, a smart sound box, a smart watch, a handheld device with a wireless communication function, a computing device, another processing device connected to a wireless modem, a robot, an uncrewed aerial vehicle, a smart driving vehicle, a smart household, a vehicle-mounted device, a medical device, a smart logistics device, a wearable device, a Wi-Fi device, a terminal device in a future 5G network or a network after 5G, or the like. This is not limited in this embodiment of this application.

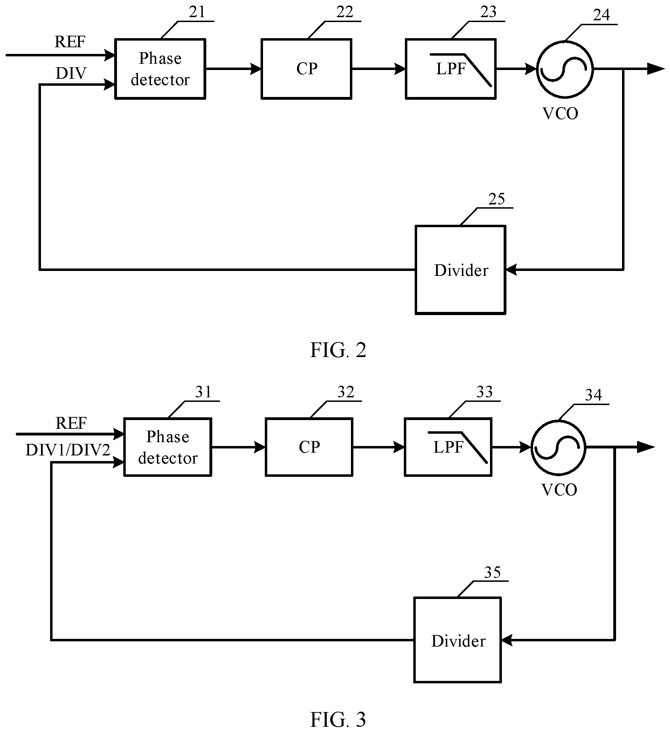

As shown in FIG. 2, a charge pump-based PLL includes a phase detector 21, a charge pump (charge pump, CP) 22, a low-pass filter (low pass filter, LPF) 23, a voltage-controlled oscillator (voltage control oscillator, VCO) 24, and a divider 25.

The phase detector 21 is configured to: receive two signals, that is, a reference signal REF and a frequency division signal DIV that is from the divider 25, and obtain, based on a difference between the two signals, a charge pump control signal related to the two signals. The charge pump control signal is also referred to as a switch control signal.

Optionally, a phase difference of the two signals may be obtained through comparison.

If a phase of the frequency division signal DIV lags behind that of the reference signal REF, the charge pump control signal output by the phase detector 21 is an UP signal, so that on/off of a current source in the CP 22 may be controlled to charge the LPF 23. If the phase of the frequency division signal DIV is ahead of that of the reference signal REF, the charge pump control signal output by the phase detector 21 is a DOWN signal, so that on/off of the current source in the CP 22 may also be controlled to discharge the LPF 23.

The CP 22 includes a current source. The current source is controlled to be on/off by the charge pump control signal generated by the phase detector 21, converts the charge pump control signal into a current pulse signal of width equal to the phase difference, and charges and discharges a load capacitor in the LPF 23 by using an on/off action.

The LPF 23 filters an output current of the CP 22 (for example, filters out a high-frequency component) and then outputs the output current to the VCO 24.

The VCO 24 is configured to adjust a frequency of an output sine wave voltage signal (also referred to as an oscillation signal) based on the output current of the LPF 23.

The divider 25 performs frequency division on the input oscillation signal from the VCO 24, and outputs one frequency division signal DIV If a frequency division value is N, it indicates N times of frequency division.

Optionally, the divider 25 may be an analog frequency divider, or may be a counter with a counting function.

The PLL synchronizes frequencies and phases of the two input signals (the reference signal REF and the frequency division signal DIV) through closed-loop control.

Optionally, a working process of the PLL may be as follows:

If the phase of the frequency division signal DIV lags behind that of the reference signal REF, a larger phase difference leads to a higher control voltage and a higher frequency of the signal output by the VCO 24. If the phase of the frequency division signal DIV is ahead of the reference signal REF, a larger phase difference leads to a lower control voltage and a lower frequency of the signal output by the VCO 24. After performing frequency division on the signal output by the VCO 24, the divider 25 obtains the frequency division signal DIV In a locked state, the frequency division signal DIV is the same as the reference signal REF in terms of frequencies. Then, the frequency division signal DIV is fed back to an input end of the phase detector 21.

Optionally, for example, the phase of the frequency division signal DIV lags behind that of the reference signal REF. If a frequency of the frequency division signal DIV is inconsistent with a frequency of the reference signal REF, it is assumed that the frequency of the frequency division signal DIV is lower than the frequency of the reference signal REF, and when the phase difference between the reference signal REF and the frequency division signal DIV increases, the control voltage increases, a frequency of the signal output by the VCO 24 increases, and the frequency of the frequency division signal DIV also increases. When the frequency of the frequency division signal DIV is the same as the frequency of the reference signal REF, and the phase of the frequency division signal DIV is the same as the phase of the reference signal REF, the PLL enters a locked state.

When the PLL works at a decimal frequency (in other words, the frequency of the signal output by the VCO 24 is the decimal frequency), because a frequency division value of the divider 25 cannot be a decimal and fluctuates around a desired frequency division value, a desired decimal frequency division value (corresponding to a desired decimal frequency) is obtained through long-term averaging, so that the phase of the frequency division signal DIV output by the divider 25 fluctuates around a desired phase (corresponding to the desired decimal frequency), and consequently, the phase difference between the reference signal REF and the frequency division signal DIV that are input by the phase detector 21 fluctuates, and phase noise of the PLL deteriorates due to such fluctuation of the phase difference.

An embodiment of this application provides a phase locked loop. After receiving an oscillation signal, a divider outputs a first frequency division signal and a second frequency division signal, and a phase of the second frequency division signal lags behind a phase of the first frequency division signal. After receiving a reference signal, the first frequency division signal, and the second frequency division signal, a phase detector outputs a plurality of charge pump control signals based on one of the first frequency division signal and the second frequency division signal and the reference signal, to control on/off of switches in a plurality of first current source units that are connected in parallel in a CP, so that a fixed current source in the first current source unit outputs a current, and after an LPF filters the current, the fixed current source outputs the current to the VCO. Because there is a phase difference between the first frequency division signal and the second frequency division signal, width of the charge pump control signal output by the phase detector is between the following two phase differences: a phase difference between the first frequency division signal and the reference signal, and a phase difference between the second frequency division signal and the reference signal. Because the reference signal always remains unchanged, a smaller phase difference between the first frequency division signal and the second frequency division signal leads to smaller variation of the width of the charge pump control signal output by the phase detector and smaller fluctuation of the oscillation signal output by the VCO, so that noise of the divider is reduced, and therefore, phase noise of the PLL working at the decimal frequency is reduced.

Specifically, as shown in FIG. 3, an embodiment of this application provides another charge pump-based PLL, including: a phase detector 31, a CP 32, an LPF 33, a VCO 34, and a divider 35.

The phase detector 31, the CP 32, the LPF 33, the VCO 34, and the divider 35 form a closed loop. A difference between functions of the components in the PLL in FIG. 3 and the functions of the components in the PLL in FIG. 2 is described below.

The VCO 34 is configured to output an oscillation signal.

The divider 35 is configured to: after receiving the oscillation signal from the VCO 34, output a first frequency division signal DIV1 and a second frequency division signal DIV2. A phase of the second frequency division signal DIV2 lags behind a phase of the first frequency division signal DIV1, for example, by one clock periodicity Tvco of the oscillation signal.

The phase detector 31 is configured to: control a current source to be on/off under the control of a charge pump control signal generated by the phase detector 21, convert the charge pump control signal into a current pulse signal of width equal to a phase difference, and charge and discharge a load capacitor in the LPF 23 by using an on/off action. The phase detector 31 may include a phase detector (phase detector, PD), a phase frequency detector (phase frequency detector, PFD), or another component used for phase detection.

The CP 32 is configured to receive a reference signal REF, the first frequency division signal DIV1, and the second frequency division signal DIV2, and is further configured to output a plurality of charge pump control signals based on the reference signal REF, the first frequency division signal DIV1, and the second frequency division signal DIV2.

The LPF 33 is configured to filter out a high-frequency component of an output current of the CP 32 and then output the output current to the VCO 34.

A possible structure of the divider 35 is described below.

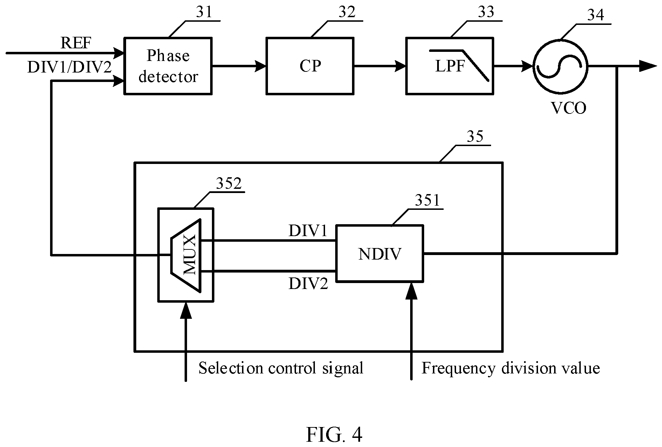

Optionally, as shown in FIG. 4, the divider 35 includes an N-divider (N-Divider, NDIV) 351 and a multiplexer (multiplexer, MUX) 352. The NDIV 351 is configured to: receive an oscillation signal and a frequency division value N from the VCO 34, perform frequency division on the oscillation signal based on the frequency division value N, and output the first frequency division signal DIV1 and the second frequency division signal DIV2. The MUX 352 is configured to: input a selection control signal, the first frequency division signal DIV1, and the second frequency division signal DIV2, select one of the first frequency division signal DIV1 and the second frequency division signal DIV2 based on the selection control signal, and output the selected frequency division signal to the phase detector 31.

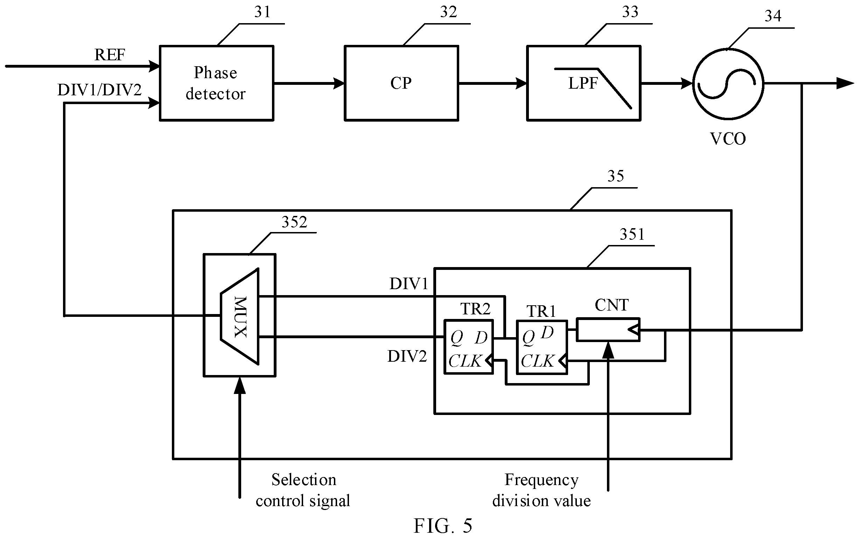

Optionally, as shown in FIG. 5, in a possible implementation, the NDIV 351 includes a counter CNT, a first trigger TR1, and a second trigger TR2. The counter CNT is configured to input the oscillation signal from the VCO 34 and perform frequency division on the oscillation signal to output an initial frequency division signal. A data input end D of the first trigger TR1 is configured to input the initial frequency division signal, and a data output end Q of the first trigger TR1 is configured to output the first frequency division signal DIV1. A data input end D of the second trigger TR2 is configured to input the first frequency division signal DIV1, and a data output end Q of the second trigger TR2 is configured to output the second frequency division signal DIV2. Clock input ends of the first trigger TR1 and the second trigger TR2 are configured to input the oscillation signal from the VCO 34, and the oscillation signal is used as a clock that drives the trigger.

Optionally, a working principle of the NDIV 351 may be as follows: After the counter CNT obtains the frequency division value N, a counting value of the counter CNT is increased by 1 in each clock periodicity Tvco of the oscillation signal output by the VCO 34, and when N is reached, the counter CNT outputs one pulse signal to the data input end D of the first trigger TR1. In a next clock periodicity Tvco of the oscillation signal output by the VCO 34, the data output end Q of the first trigger TR1 outputs one pulse signal, that is, the first frequency division signal DIV1, to the data input end D of the second trigger TR2 and the MUX 352. In a still next clock periodicity Tvco of the oscillation signal output by the VCO 34, the data output end Q of the second trigger TR2 outputs one pulse signal, that is, the second frequency division signal DIV2. Therefore, a phase of the first frequency division signal DIV1 and a phase of the second frequency division signal DIV2 sequentially differ by one clock periodicity Tvco of the oscillation signal.

In addition, to make the phase of the first frequency division signal DIV1 and the phase of the second frequency division signal DIV2 differ by more clock periodicities Tvco, more triggers may be connected in series.

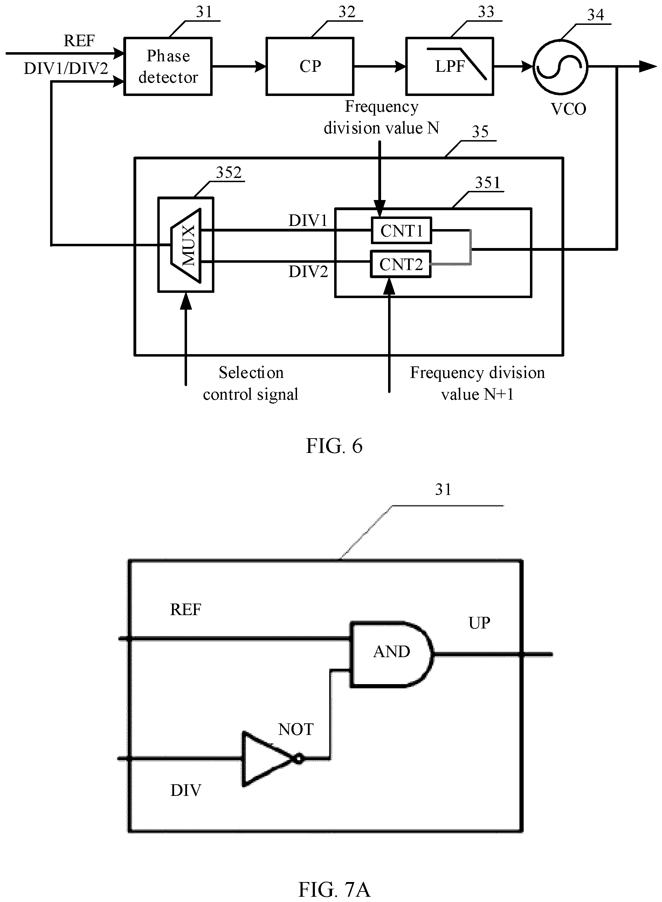

Optionally, as shown in FIG. 6, in another possible implementation, the NDIV 351 includes a first counter CNT1 and a second counter CNT2. The first counter CNT1 is configured to input the oscillation signal from the VCO 34 and perform frequency division on the oscillation signal to output the first frequency division signal DIV1. The second counter CNT2 is configured to input the oscillation signal from the VCO 34 and perform frequency division on the oscillation signal to output the second frequency division signal DIV2. A frequency division value input into the second counter CNT2 is greater than a frequency division value input into the first counter CNT1. For example, the frequency division value input into the first counter CNT1 is N, and the frequency division value input into the first counter CNT1 is N+1.

Optionally, a working principle of the NDIV 351 may be as follows: The frequency division value N is input into the first counter CNT1, and the frequency division value N+1 is input into the second counter CNT2. In each clock periodicity Tvco of the oscillation signal output by the VCO 34, a counting value of each counter is increased by 1. When N is reached, the first counter CNT 1 outputs one pulse signal, that is, the first frequency division signal DIV1. In a next clock periodicity Tvco of the oscillation signal output by the VCO 34, the second counter CNT2 outputs one pulse signal, that is, the second frequency division signal DIV2. Therefore, the phase of the first frequency division signal DIV1 and the phase of the second frequency division signal DIV2 differ by one clock periodicity Tvco of the oscillation signal.

In addition, if the phase of the first frequency division signal DIV1 and the phase of the second frequency division signal DIV2 differ by more clock periodicities Tvco, only a difference between frequency division values input by the second counter CNT2 needs to be added.

A possible structure of the phase detector 31 is described below.

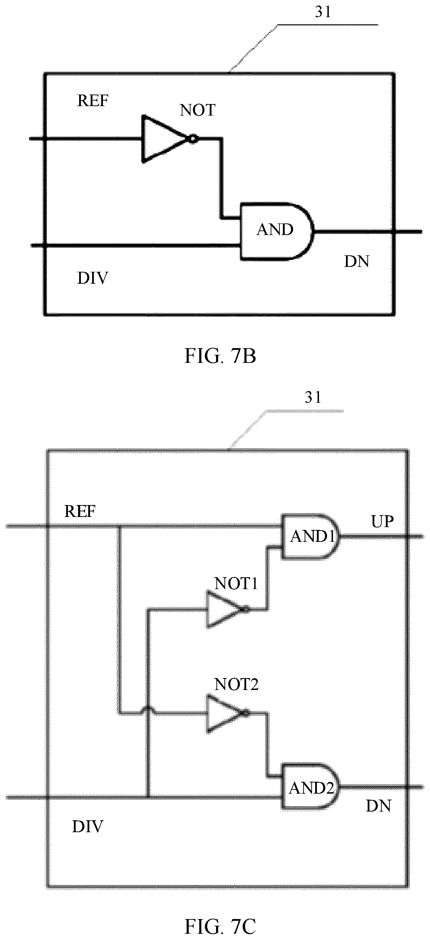

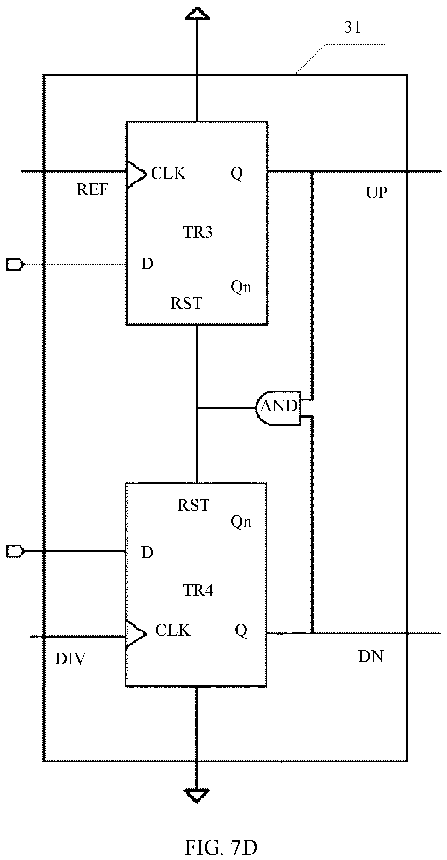

Optionally, as shown in FIG. 7A, FIG. 7B, FIG. 7C, and FIG. 7D, the phase detector 31 includes at least a reference signal end REF and a frequency division signal end DIV, and further includes at least one of a charging signal end UP and a discharging signal end DOWN.

For FIG. 7A, the phase detector 31 includes a NOT gate NOT and an AND gate AND. The NOT gate NOT is configured to invert a phase of the first frequency division signal or the second frequency division signal and then output the phase-inverted first frequency division signal or second frequency division signal to the AND gate AND, and the AND gate AND is configured to perform an AND operation on the phase-inverted first frequency division signal or second frequency division signal and the reference signal and then output an UP signal (a charge pump control signal whose function is described later). This structure is a PD.

For FIG. 7B, the phase detector 31 includes a NOT gate NOT and an AND gate AND. The NOT gate NOT is configured to invert a phase of the reference signal and output the phase-inverted reference signal to the AND gate AND, and the AND gate AND is configured to perform an AND operation on the first frequency division signal or the second frequency division signal and the phase-inverted reference signal and then output a DOWN signal (a charge pump control signal whose function is described later). This structure is a PD.

For FIG. 7C, the phase detector 31 includes a first NOT gate NOT1, a second NOT gate NOT2, a first AND gate AND1, and a second AND gate AND2. C is a combination of FIG. 7A and FIG. 7B. The first NOT gate NOT1 is configured to invert a phase of the first frequency division signal or the second frequency division signal and then output the phase-inverted first frequency division signal or second frequency division signal to the first AND gate AND1, the second NOT gate NOT2 is configured to invert a phase of the reference signal and then output the phase-inverted reference signal to the second AND gate AND2, the first AND gate AND 1 is configured to perform an AND operation on the phase-inverted first frequency division signal or second frequency division signal and the reference signal and then output an UP signal, and the second AND gate AND2 is configured to perform an AND operation on the first frequency division signal or the second frequency division signal and the phase-inverted reference signal and then output a DOWN signal. This structure is a PD.

For FIG. 7D, the phase detector 31 includes a third trigger, a fourth trigger, and an AND gate AND. A clock input end CLK of the third trigger TR3 is configured to input the reference signal, and a data output end Q of the third trigger TR3 is configured to output the UP signal. A clock input end CLK of the fourth trigger TR4 is configured to input the first frequency division signal or the second frequency division signal, and a data output end Q of the fourth trigger TR4 is configured to output the DOWN signal. A first input end of the AND gate AND is configured to input the UP signal, a second input end of the AND gate AND is configured to input the DOWN signal, and an output end of the AND gate is coupled to reset input ends RST of the third trigger TR3 and the fourth trigger TR4. This structure is a PFD.

This application is not limited to the foregoing examples, and any phase detector that compares a phase of the reference signal and a frequency of the frequency division signal may be applied to this embodiment of this application.

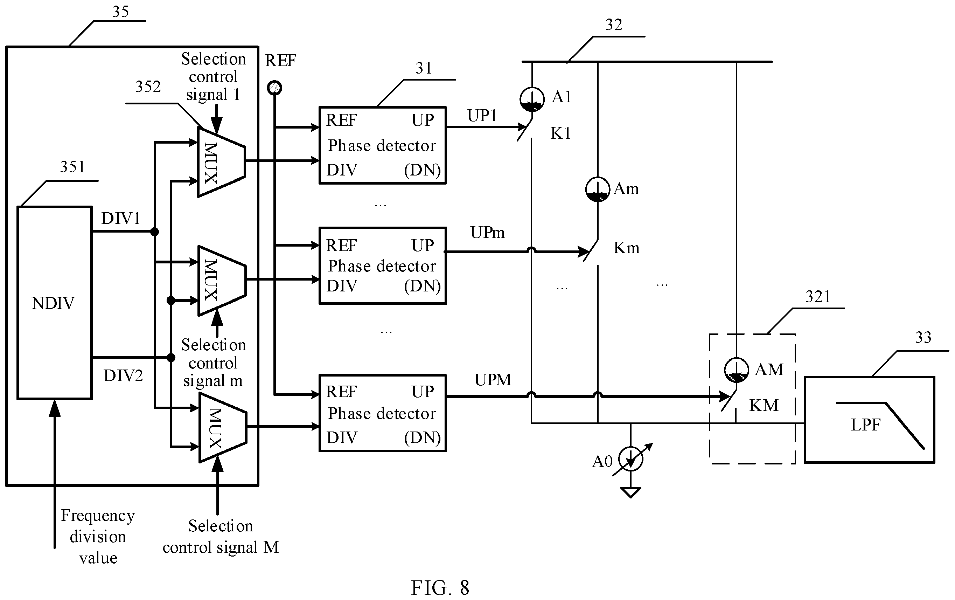

As shown in FIG. 8 to FIG. 10, when M (M is a positive integer) phase detectors 31 are connected in parallel, a plurality of charge pump control signals may be output. Correspondingly, the divider 35 may include M MUXs 352 connected in parallel, and each MUX 352 is controlled by an independent selection control signal, to output one of the first frequency division signal and the second frequency division signal to the corresponding phase detector 31.

A possible structure of the CP 32 is described below.

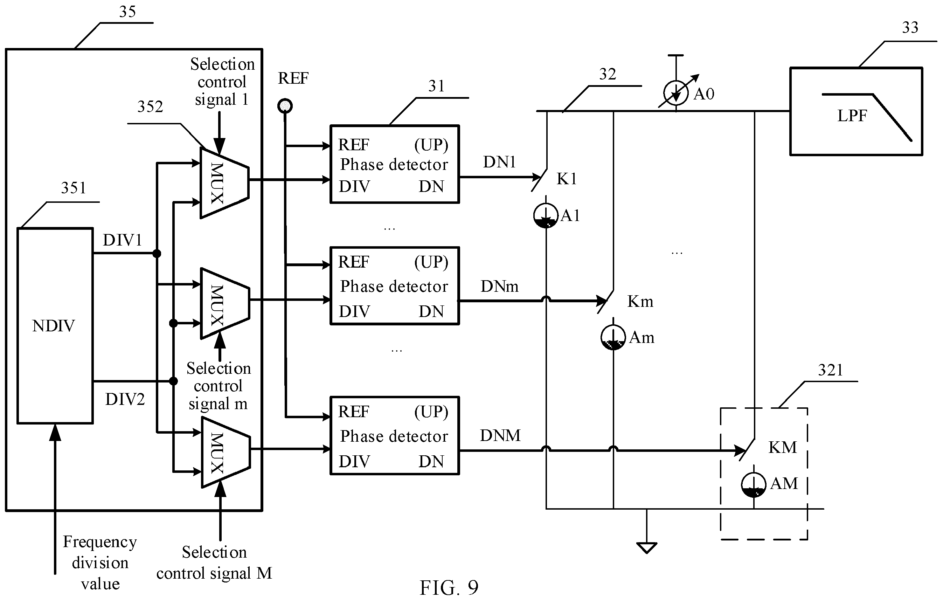

Optionally, in a possible implementation, as shown in FIG. 8 and FIG. 9, the CP 32 includes a variable current source A0 and a plurality of first current source units 321 connected in parallel, the plurality of first current source units 321 and the variable current source A0 are coupled to the output end of the CP, and each first current source unit 321 includes a fixed current source (A1 to AM) and a switch (K1 to KM) that are connected in series. The variable current source A0 is configured to receive an offset control signal independent of the plurality of charge pump control signals, and the offset control signal is used to adjust a current value of the variable current source A0. The plurality of charge pump control signals output by the phase detector 31 are used to separately control on/off of switches (K1 to KM) of the plurality of first current source units 321. Therefore, the first current source unit may also be referred to as a switch current source.

As shown in FIG. 8 and FIG. 9, the plurality of first current source units 321 are connected in parallel, and are connected to the variable current source A0 in series and coupled to the output end of the CP. A connection point between the variable current source A0 and the plurality of first current source units 321 is used to connect to an input end of the LPF 33. As shown in FIG. 8, when the charge pump control signal is an UP signal, the variable current source A0 is grounded, and fixed current sources (A1 to AM) of the plurality of first current source units 321 are connected to a power supply. As shown in FIG. 9, when the charge pump control signal is a DOWN signal, the variable current source A0 is connected to a power supply, and fixed current sources (A1 to AM) of the plurality of first current source units 321 are grounded.

The charge pump control signal includes an UP signal (UP1 to UPM) in FIG. 8 or a DOWN signal (DN1 to DNM) in FIG. 9. The UP signal may also be referred to as a charging signal. When the UP signal takes effect (for example, control the switches K1 to KM to be conducted), the CP 32 charges a capacitor in the LPF 33 by using the fixed current sources (A1 to AM) in the plurality of first current source units 321. The DOWN signal may also be referred to as a discharging signal. When the DOWN signal takes effect (for example, control the switches K1 to KM to be conducted), the CP 32 discharges a capacitor in the LPF 33 by using the current sources (A1 to AM) in the plurality of first current source units 321.

The offset control signal reduces noise of the CP 32 by adjusting the current value of the variable current source A0, so that phase noise of the PLL working at a decimal frequency is reduced. A principle is as follows:
FIG. 8 is used as an example. In an entire periodicity Tref of the reference signal REF, the CP 32 charges the capacitor in the LPF 33 by using the fixed current sources (A1 to AM) in the plurality of first current source units 321. In the periodicity Tref, a charging charge of the LPF 33 is Q1=Σ(Icp_up^{∗}Tup), a discharging charge of the LPF 33 is Q2=Ioffset_dn*Tref, and the charging charge and the discharging charge are equal (Q1=Q2). Icp_up is a charging current of the fixed current source (A1 to AM), Tup is charging time of the fixed current source (A1 to AM), Ioffset_dn is a discharging current of the variable current source A0, and Tref is a periodicity of the reference signal REF. Because Tref and Icp_up remain unchanged, when the current value (that is, the discharging current Ioffset_dn) of the variable current source A0 can be reduced, the charging time Tup of the fixed current source (A1 to AM) can be reduced. However, noise of the CP is related to the charging time. Shorter charging time leads to lower noise of the CP. Therefore, when the current value of the variable current source A0 is reduced, the noise of the CP 32 can be reduced, so that the phase noise of the PLL working at the decimal frequency is reduced.

FIG. 9 is used as an example. In the entire periodicity Tref of the reference signal REF, the CP 32 discharges the capacitor in the LPF 33 by using the fixed current sources (A1 to AM) in the plurality of first current source units 321. In the periodicity Tref, a discharging charge of the LPF 33 is Q1=Σ(Icp_dn^{∗}Tdn), a charging charge of the LPF 33 is Q2=Ioffset_up^{∗}Tref, and the charging charge and the discharging charge are equal (Q1=Q2). Icp_dn is a discharging current of the fixed current source (A1 to AM), Tdn is discharging time of the fixed current source (A1 to AM), Ioffset_up is a charging current of the variable current source A0, and Tref is a periodicity of the reference signal REF. Because Tref and Icp_dn remain unchanged, when the current value (that is, the charging current Ioffset_up) of the variable current source A0 can be reduced, the discharging time Tdn of the fixed current source (A1 to AM) can be reduced. However, noise of the CP is related to the charging time. Shorter charging time leads to lower noise of the CP. Therefore, when the current value of the variable current source A0 is reduced, the noise of the CP 32 can be reduced, so that the phase noise of the PLL working at the decimal frequency is reduced.

In FIG. 8, the phase detector 31 includes a charging signal end UP, and a discharging signal end DN is optional. For example, circuit structures shown in FIG. 7A, FIG. 7C, and FIG. 7D may be used.

In FIG. 9, the phase detector 31 includes a discharging signal end DN, and a charging signal end UP is optional. For example, circuit structures shown in FIG. 7B, FIG. 7C, and FIG. 7D may be used.

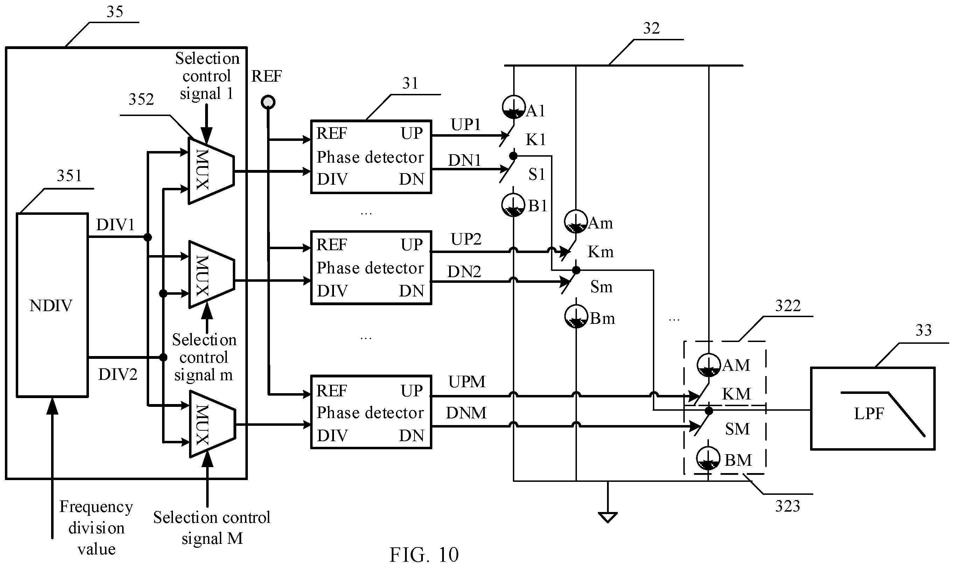

Optionally, in another possible implementation, as shown in FIG. 10, the CP 32 includes a plurality of (M) groups of current sources connected in parallel, each group of current sources includes a first current source unit 322 and a second current source unit 323 that are connected in series, the first current source unit 322 includes a first fixed current source (A1 to AM) and a first switch (K1 to KM), and the second current source unit 323 includes a second fixed current source (B1 to BM) and a second switch (S1 to SM). A plurality of charge pump control signals output by the phase detector 31 are used to separately control on/off of the first switch (K1 to KM) and the second switch (S1 to SM).

Optionally, the first fixed current source (A1 to AM) is connected to a power supply, the second fixed current source (B1 to BM) is grounded, and a connection point between the first current source unit 322 and the second current source unit 323 is used to connect to the input end of the LPF 33.

Similar to FIG. 8 or FIG. 9, the charge pump control signal includes an UP signal (UP1 to UPM) and a DOWN signal (DN1 to DNM), the UP signal is used to control on/off of the first switch (K1 to KM), and the DOWN signal is used to control on/off of the second switch (S1 to SM). The UP signal may also be referred to as a charging signal. When the UP signal takes effect (for example, control the first switch (K1 to KM) to be conducted), the CP 32 charges a capacitor in the LPF 33 by using the plurality of first fixed current sources (A1 to AM). The DOWN signal may also be referred to as a discharging signal. When the DOWN signal takes effect (for example, control the second switch (S1 to SM) to be conducted), the CP 32 discharges the capacitor in the LPF 33 by using the plurality of second current sources (B1 to BM).

In an entire periodicity Tref of the reference signal REF, a discharging charge of the LPF 33 is Q1=Σ(Icp_dn^{∗}Tdn), the charging charge of the LPF 33 is Q1=Σ(Icp_up^{∗}Tup), and the discharging charge and the charging charge are equal (Q1=Q2). Icp_up is a charging current of the first fixed current source (A1 to AM), Tup is charging time of the first fixed current source (A1 to AM), Icp_dn is a discharging current of the second fixed current source (B1 to BM), and Tdn is discharging time of the second fixed current source (B1 to BM).

In FIG. 10, the phase detector 31 includes a charging signal end UP and a discharging signal end DN. For example, circuit structures shown in FIG. 7C and FIG. 7D may be used.

Optionally, a working manner of the PLL is: The divider obtains at least two different frequency division values in M reference signal periodicities. In a possible implementation, in one of the M reference signal periodicities, the divider obtains a frequency division value N+1, and in remaining M-1 reference signal periods, the divider obtains a frequency division value N. The N MUXs in the divider randomly output one of the first frequency division signal and the second frequency division signal.

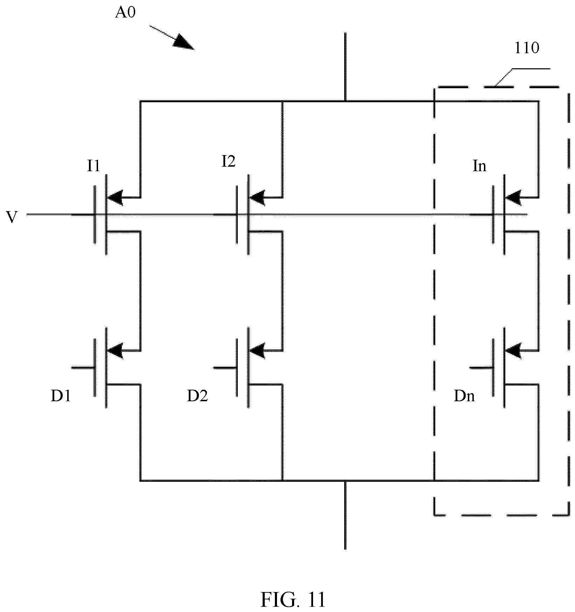

In a possible implementation, as shown in FIG. 11, the variable current source A0 in FIG. 8 or FIG. 9 includes a plurality of third current source units 110 connected in parallel, each third current source unit 110 includes image constant current sources (also referred to as current mirrors) I1 to In and switching transistors D1 to Dn that are connected in series, gates of the image constant current sources I1 to In in each third current source unit are controlled by a same bias voltage V, and on/off of the switching transistors D1 to Dn is controlled by an offset control signal (for example, by using a register). A larger quantity of conducted switching transistors leads to a larger current of the variable current source A0.

According to the phase locked loop and the radio frequency transceiver provided in embodiments of this application, in one aspect, as shown in FIG. 8 to FIG. 10, the first frequency division signal and the second frequency division signal are output by using the divider in the phase locked loop, so that width of the charge pump control signal output by the phase detector in the phase locked loop is between the following two phase differences: a phase difference between the first frequency division signal and the reference signal, and a phase difference between the second frequency division signal and the reference signal. Because the reference signal always remains unchanged, a smaller phase difference between the first frequency division signal and the second frequency division signal leads to smaller variation of the width of the charge pump control signal output by the phase detector and smaller fluctuation of the oscillation signal output by the VCO, so that noise of the divider is reduced, and therefore, phase noise of the PLL working at the decimal frequency is reduced. In another aspect, as shown in FIG. 8 and FIG. 9, the CP in the phase locked loop includes the fixed current source and the variable current source with an adjustable size. When the size of the variable current source is reduced, charging and discharging time of the fixed current source can be reduced, noise of the CP is reduced, and the phase noise of the PLL working at the decimal frequency is reduced. In addition, the variable current source with an adjustable size is used in the CP, so that the phase locked loop can adjust charging and discharging time of the CP in a specific range, to optimize performance of the phase locked loop in a specific parameter range.

A person of ordinary skill in the art may be aware that, in combination with the examples described in embodiments disclosed in this specification, units and algorithm steps may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, refer to a corresponding process in the foregoing method embodiments, and details are not described herein again.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A phase locked loop, comprising a phase detector, a charge pump CP, a low-pass filter LPF, a voltage-controlled oscillator VCO, and a divider, wherein
the VCO is configured to output an oscillation signal;
the divider is configured to output a first frequency division signal and a second frequency division signal after receiving the oscillation signal;
the phase detector is configured to receive a reference signal, the first frequency division signal, and the second frequency division signal, and is further configured to output a plurality of charge pump control signals based on one of the first frequency division signal and the second frequency division signal and the reference signal;
the CP comprises a variable current source and a plurality of first current source units that are connected in parallel, and the variable current source and the plurality of first current source units are coupled to an output end of the charge pump; each first current source unit comprises a fixed current source and a switch that are connected in series, the variable current source is configured to receive an offset control signal, and the offset control signal is configured to adjust a current value of the variable current source; and the plurality of charge pump control signals are used to control on/off of switches of the plurality of first current source units; and
the LPF is configured to filter an output current of the CP and output the output current to the VCO.

2. The phase locked loop according to claim 1, wherein the plurality of first current source units are connected in parallel, and are connected to the variable current source in series and coupled to the output end of the charge pump, and when the charge pump control signal is a discharge DOWN signal, the variable current source is connected to a power supply, and fixed current sources of the plurality of first current source units are grounded.

3. The phase locked loop according to claim 1, wherein the plurality of first current source units are connected in parallel, and are connected to the variable current source in series and coupled to the output end of the charge pump, and when the charge pump control signal is a charge UP signal, the variable current source is grounded, and fixed current sources of the plurality of first current source units are connected to a power supply.

4. The phase locked loop according to claim 1 or 2, wherein the phase detector comprises a NOT gate and an AND gate, the NOT gate is configured to invert a phase of the reference signal and then output the phase-inverted reference signal to the AND gate, and the AND gate is configured to perform an AND operation on the first frequency division signal or the second frequency division signal and the phase-inverted reference signal and then output a DOWN signal.

5. The phase locked loop according to claim 1 or 3, wherein the phase detector comprises a NOT gate and an AND gate, the NOT gate is configured to invert a phase of the first frequency division signal or the second frequency division signal and then output the phase-inverted first frequency division signal or second frequency division signal to the AND gate, and the AND gate is configured to perform an AND operation on the phase -inverted first frequency division signal or second frequency division signal and the reference signal and then output an UP signal.

6. The phase locked loop according to any one of claims 1 to 3, wherein the phase detector comprises a first AND gate, a second AND gate, a first NOT gate, and a second NOT gate, the first NOT gate is configured to invert a phase of the first frequency division signal or the second frequency division signal and then output the phase-inverted first frequency division signal or second frequency division signal to the first AND gate, the second NOT gate is configured to invert a phase of the reference signal and then output the phase-inverted reference signal to the second AND gate, the first AND gate is configured to perform an AND operation on the phase -inverted first frequency division signal or second frequency division signal and the reference signal and then output an UP signal, and the second AND gate is configured to perform an AND operation on the first frequency division signal or the second frequency division signal and the phase-inverted reference signal and then output a DOWN signal.

7. The phase locked loop according to any one of claims 1 to 3, wherein the phase detector comprises a third trigger, a fourth trigger, and an AND gate; and
a clock input end of the third trigger is configured to input the reference signal, and a data output end of the third trigger is configured to output the UP signal; a clock input end of the fourth trigger is configured to input the first frequency division signal or the second frequency division signal, and a data output end of the fourth trigger is configured to output the DOWN signal; and a first input end of the AND gate is configured to input the UP signal, a second input end of the AND gate is configured to input the DOWN signal, and an output end of the AND gate is coupled to reset input ends of the third trigger and the fourth trigger.

8. The phase locked loop according to any one of claims 1 to 7, wherein the divider comprises an N-divider NDIV and a multiplexer MUX;
the NDIV is configured to: receive the oscillation signal and a frequency division value, perform frequency division on the oscillation signal based on the frequency division value, and output the first frequency division signal and the second frequency division signal; and
the MUX is configured to: after a selection control signal, the first frequency division signal, and the second frequency division signal are input, select one of the first frequency division signal and the second frequency division signal based on the selection control signal, and output the selected frequency division signal to the phase detector.

9. The phase locked loop according to claim 8, wherein the NDIV comprises a counter, a first trigger, and a second trigger, the counter is configured to input the oscillation signal and perform frequency division on the oscillation signal to output an initial frequency division signal, a data input end of the first trigger is configured to input the initial frequency division signal, a data output end of the first trigger is configured to output the first frequency division signal, a data input end of the second trigger is configured to input the first frequency division signal, and a data output end of the second trigger is configured to output the second frequency division signal.

10. The phase locked loop according to any one of claims 1 to 9, wherein the variable current source comprises a plurality of third current source units that are connected in parallel, each third current source unit comprises an image constant current source and a switching transistor that are connected in series, a gate of the image constant current source is controlled by a same bias voltage, and on/off of the switching transistor is controlled by the offset control signal.

11. The phase locked loop according to any one of claims 1 to 10, wherein a phase of the second frequency division signal lags behind a phase of the first frequency division signal.

12. The phase locked loop according to any one of claims 1 to 11, wherein the phase detector comprises a phase detector PD or a phase frequency detector PFD.

13. A radio frequency transceiver, comprising the phase locked loop according to any one of claims 1 to 12, a local oscillator, and a plurality of groups of radio frequency circuits, wherein each group of radio frequency circuits comprises a first mixer and a low noise amplifier;
the phase locked loop is configured to output a first oscillation signal to the local oscillator, and the local oscillator is configured to process the first oscillation signal and output a receive oscillation signal; and
in each group of radio frequency circuits,
the first mixer is configured to mix the receive oscillation signal and a signal that is output by the low noise amplifier.

14. A radio frequency transceiver, comprising the phase locked loop according to any one of claims 1 to 12, a local oscillator, and a plurality of groups of radio frequency circuits, wherein each group of radio frequency circuits comprises a second mixer and a power amplifier;
the phase locked loop is configured to output a first oscillation signal to the local oscillator, and the local oscillator is configured to process the first oscillation signal and output a transmit oscillation signal; and
in each group of radio frequency circuits,
the second mixer is configured to mix the transmit oscillation signal and output the transmit oscillation signal to the power amplifier.
